# EUROPEAN PATENT SPECIFICATION

(11) **EP 4 506 656 B1**
(45) Date of publication and mention of the grant of the patent: **18.02.2026**
(21) Application number: 24192030.5
(22) Date of filing: 31.07.2024
(51) Int. Cl.: G01B 11/25, G06T 7/11, G06T 7/50

(54) **THREE-DIMENSIONAL MEASUREMENT DEVICE, COMPONENT MOUNTING APPARATUS, AND THREE-DIMENSIONAL MEASUREMENT METHOD**
DREIDIMENSIONALE MESSVORRICHTUNG, KOMPONENTENMONTAGEVORRICHTUNG UND DREIDIMENSIONELLES MESSVERFAHREN
DISPOSITIF DE MESURE TRIDIMENSIONNELLE, DISPSITIF DE MONTAGE DE COMPOSANT ET PROCÉDÉ DE MESURE TRIDIMENSIONELLE

(30) Priority: 01.08.2023 JP 2023125270
(43) Date of publication of application: 12.02.2025
(73) Proprietor: JUKI Corporation, Tama-shi, Tokyo 206-8551 (JP)
(72) Inventor: YAMADA, Tomomi, Tokyo, 206-8551 (JP); YAMADA, Kazunori, Tokyo, 206-8551 (JP); OGURA, Yutaka, Tokyo, 206-8551 (JP)
(74) Representative: Hoeger, Stellrecht & Partner Patentanwälte mbB

(56) References cited:
- JP-A- 2023 054 992
- US-A- 5 988 862
- US-A1- 2015 217 451

## Description

### TECHNICAL FIELD

The technology disclosed in the present specification relates to a three-dimensional measurement device, a component mounting apparatus, and a three-dimensional measurement method.

### BACKGROUND ART

In the technical field related to component mounting apparatuses, there is known an electronic component mounting apparatus including a three-dimensional measurement device, as disclosed in JP 2019 144137 A.

Further, US 5,988,862 discloses an integrated system for quickly and accurately imaging and modeling three dimensional objects. A component mounting device and a component mounting method are known from JP 2023 054992 A. A robot, a robot system, a control device, and a control method are described in US 2015/0217451 A1.

### SUMMARY OF INVENTION

In order to efficiently produce electronic devices using a component mounting apparatus, it is desired to accelerate measurement processing of a three-dimensional shape of at least part of a component mounted on a substrate.

Therefore, it is an object of the invention to improve a three-dimensional measurement device for accelerating measurement processing of a three-dimensional shape of at least part of a component mounted on a substrate for efficiently producing electronic devices with a component mounting apparatus.

This object is achieved in accordance with the invention by a three-dimensional measurement device as defined in claim 1 and by a component mounting apparatus as defined in claim 9. Preferred embodiments are defined in the dependent claims.

The present specification discloses a three-dimensional measurement device.

The three-dimensional measurement device includes a model point cloud data storage unit in which model point cloud data representing three-dimensional point cloud data of a model of a protrusion protruding from a body portion of a component is stored, a computing range determination unit configured to compare the model point cloud data with detection point cloud data representing three-dimensional point cloud data of the component detected by a three-dimensional sensor to determine a computing range of the detection point cloud data, and a three-dimensional shape calculation unit configured to calculate a three-dimensional shape of the protrusion based on the detection point cloud data in the computing range.

According to the technology disclosed in the present specification, measurement processing of the three-dimensional shape of at least part of a component is accelerated.

### BRIEF DESCRIPTION OF DRAWINGS

FIG. 1 is a perspective view showing a component mounting apparatus according to an embodiment.
FIG. 2 is a side view showing the component mounting apparatus according to the embodiment.
FIG. 3 is a perspective view showing a robot hand according to the embodiment.
FIG. 4 is a side view showing a component held by the robot hand according to the embodiment.
FIG. 5 shows the component according to the embodiment as viewed from below.
FIG. 6 is a perspective view showing a three-dimensional measurement device according to the embodiment.
FIG. 7 is a diagram for illustrating an operation of a robot manipulator according to the embodiment.
FIG. 8 is a block diagram showing the component mounting apparatus according to the embodiment.

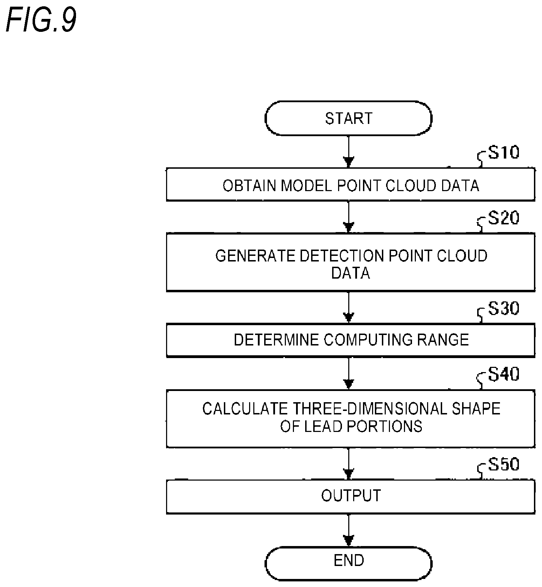

FIG. 9 is a flowchart showing a three-dimensional measurement method for lead portions according to the embodiment.
FIG. 10 schematically shows an example of model point cloud data according to the embodiment.
FIG. 11 schematically shows an example of detection point cloud data according to the embodiment.
FIG. 12 is a diagram for illustrating a computing range determination method according to the embodiment.
FIG. 13 schematically shows an example of partial point cloud data according to the embodiment.
FIG. 14 is a block diagram showing a computer system according to the embodiment.
FIG. 15 is a flowchart showing a three-dimensional measurement method for lead portions according to an embodiment.
FIG. 16 is a diagram for illustrating a relationship between a size of a lead portion and a resolution according to the embodiment.

### DESCRIPTION OF EMBODIMENTS

Hereinafter, embodiments of the present disclosure will be described with reference to the drawings, but the present disclosure is not limited to the embodiments. Components of the embodiments described below can be combined appropriately. In addition, some components may not be used.

In the embodiments, a local coordinate system is set for a component mounting apparatus 1, and a positional relationship of each part will be described with reference to the local coordinate system. As the local coordinate system, an XYZ orthogonal coordinate system is set. A direction parallel to an X-axis in a predetermined plane is referred to as an X-axis direction. A direction parallel to a Y-axis orthogonal to the X-axis in the predetermined plane is referred to as a Y-axis direction. A direction parallel to a Z-axis orthogonal to each of the X and Y axes is referred to as a Z-axis direction. A direction of rotation or inclination about the X axis is referred to as a θX direction. A direction of rotation or inclination about the Y axis is referred to as a θY direction. A direction of rotation or inclination about the Z-axis is referred to as a θZ direction. The predetermined plane is an XY plane. The Z-axis is orthogonal to the predetermined plane. In the embodiments, the predetermined plane is assumed to be parallel to a horizontal plane. The Z-axis direction is a vertical direction. Note that the predetermined plane may be inclined with respect to the horizontal surface.

### First Embodiment, not part of the claimed invention

A first embodiment , which is not part of the claimed invention, will be described.

### [Component Mounting Apparatus]

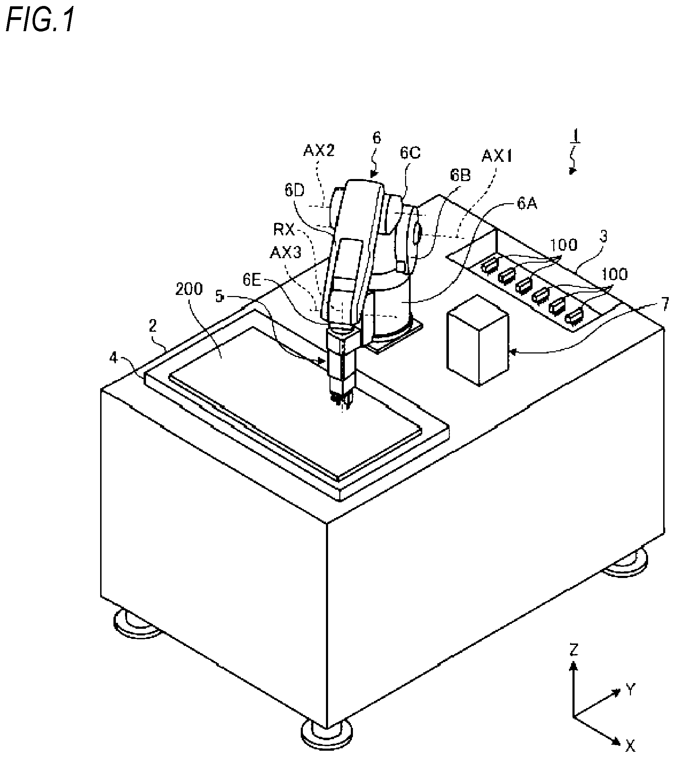

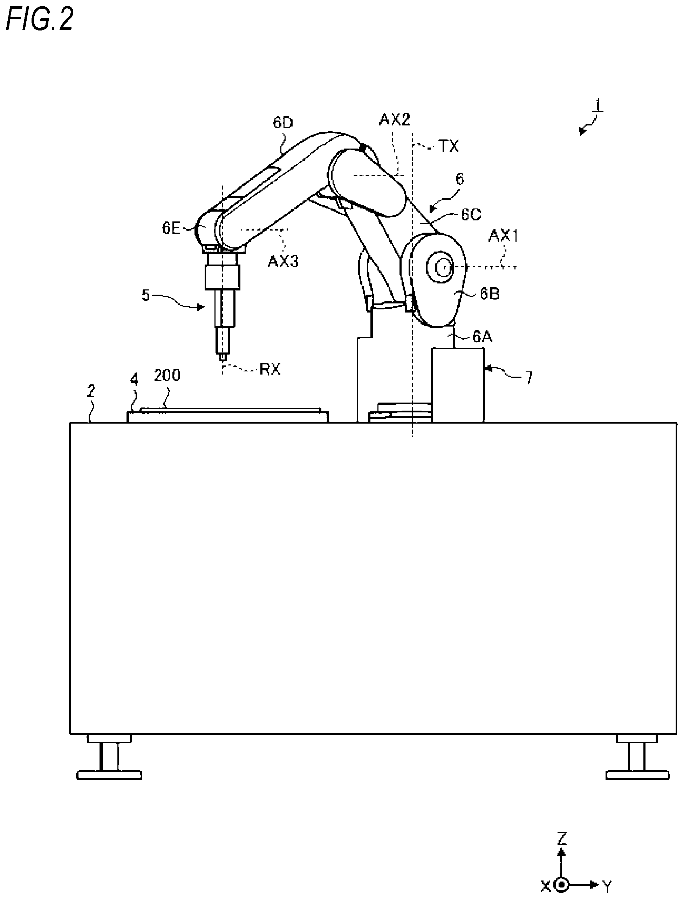

FIG. 1 is a perspective view showing a component mounting apparatus 1 according to an embodiment. FIG. 2 is a side view showing the component mounting apparatus 1 according to the embodiment. The component mounting apparatus 1 mounts a component 100 on a substrate 200.

As shown in FIGS. 1 and 2, the component mounting apparatus 1 includes a base 2, a component supply member 3, a substrate support member 4, a robot hand 5, a robot manipulator 6, and a three-dimensional measurement device 7.

The base 2 supports each of the component supply member 3, the substrate support member 4, the robot manipulator 6, and the three-dimensional measurement device 7.

The component supply member 3 supplies a component 100. In the embodiment, the component supply member 3 includes a tray on which the component 100 is arranged. A plurality of components 100 are arranged on the component supply member 3. The types of the plurality of components 100 may be the same or different.

The substrate support member 4 supports the substrate 200 on which the component 100 is mounted. The substrate support member 4 supports the substrate 200 so that an upper surface of the substrate 200 and the XY plane are parallel.

The robot hand 5 holds the component 100. The robot hand 5 is provided at a tip end portion of the robot manipulator 6.

The robot manipulator 6 moves the robot hand 5. The robot manipulator 6 holds the component 100 via the robot hand 5. The robot manipulator 6 drives while maintaining the component 100 mounted on the substrate 200. The robot manipulator 6 includes an articulated robot. In the embodiment, the robot manipulator 6 is a vertical articulated robot. Note that the robot manipulator 6 may be a horizontal articulated robot. The robot manipulator 6 includes a base member 6A fixed to the base 2, a turning member 6B supported by the base member 6A, a first arm 6C connected to the turning member 6B, a second arm 6D connected to the first arm 6C, and a third arm 6E connected to the second arm 6D.

The turning member 6B is supported by the base member 6A so as to be turnable about a turning axis TX. The turning axis TX is parallel to the Z-axis. The first arm 6C is connected to the turning member 6B so as to be revolvable about a first revolving axis AX1. The first revolving axis AX1 is orthogonal to the Z-axis. The second arm 6D is connected to the first arm 6C so as to be revolvable about a second revolving axis AX2. The second revolving axis AX2 is parallel to the first revolving axis AX1. The third arm 6E is connected to the second arm 6D so as to be revolvable about a third revolving axis AX3. The third revolving axis AX3 is parallel to the second revolving axis AX2. The robot hand 5 is attached to the third arm 6E.

The robot manipulator 6 includes a turning actuator that turns the turning member 6B, a first revolving actuator that revolves the first arm 6C, a second revolving actuator that revolves the second arm 6D, and a third revolving actuator that revolves the third arm 6E.

The three-dimensional measurement device 7 measures the component 100 held by the robot manipulator 6 via the robot hand 5. The three-dimensional measurement device 7 measures a three-dimensional shape of the component 100 based on a phase shift method. In addition, the three-dimensional measurement device 7 detects a position and an angle of the component 100 in the local coordinate system based on the phase shift method.

### [Robot Hand]

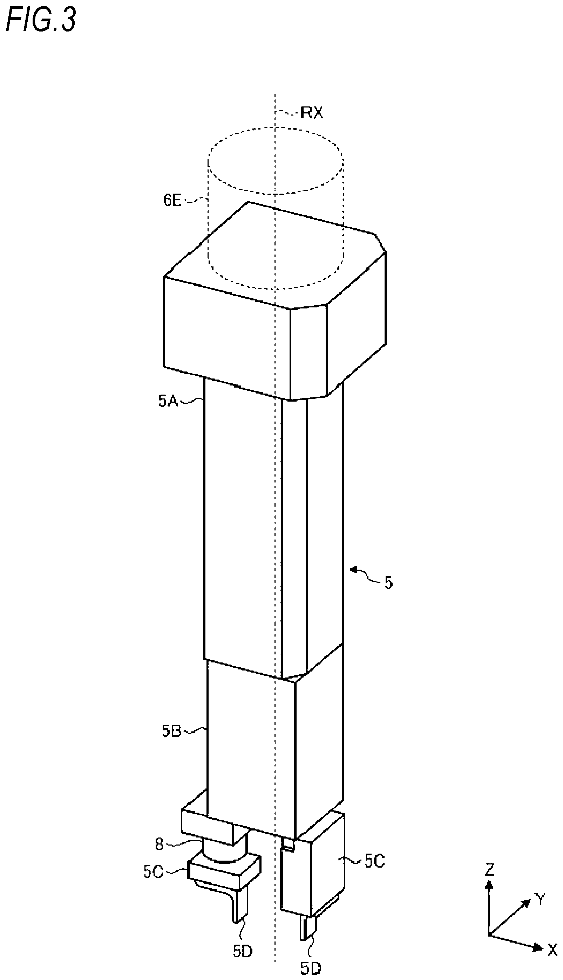

FIG. 3 is a perspective view showing the robot hand 5 according to the embodiment. The robot hand 5 has a connecting member 5A attached to the third arm 6E, a rotating member 5B supported by the connecting member 5A, and a pair of moving members 5C supported by the rotating member 5B.

The rotating member 5B is supported by the connecting member 5A so as to be rotatable about a rotation axis RX. The rotation axis RX is orthogonal to the third revolving axis AX3. The pair of moving members 5C move in directions toward and away from each other. A grip portion 5D is provided at a lower end portion of the moving member 5C. The pair of grip portions 5D moves toward and away from each other.

The robot hand 5 has a rotating actuator that rotates the rotating member 5B and a grip actuator that brings the pair of moving members 5C close to or apart from each other.

With the component 100 arranged between the pair of grip portions 5D, the pair of grip portions 5D moves toward each other, so that the component 100 is held by the grip portions 5D. The pair of grip portions 5D moves away from each other, so that the component 100 is released from the grip portions 5D.

A force sensor 8 is arranged on one moving member 5C. The force sensor 8 can detect a load applied to the grip portion 5D.

### [Component]

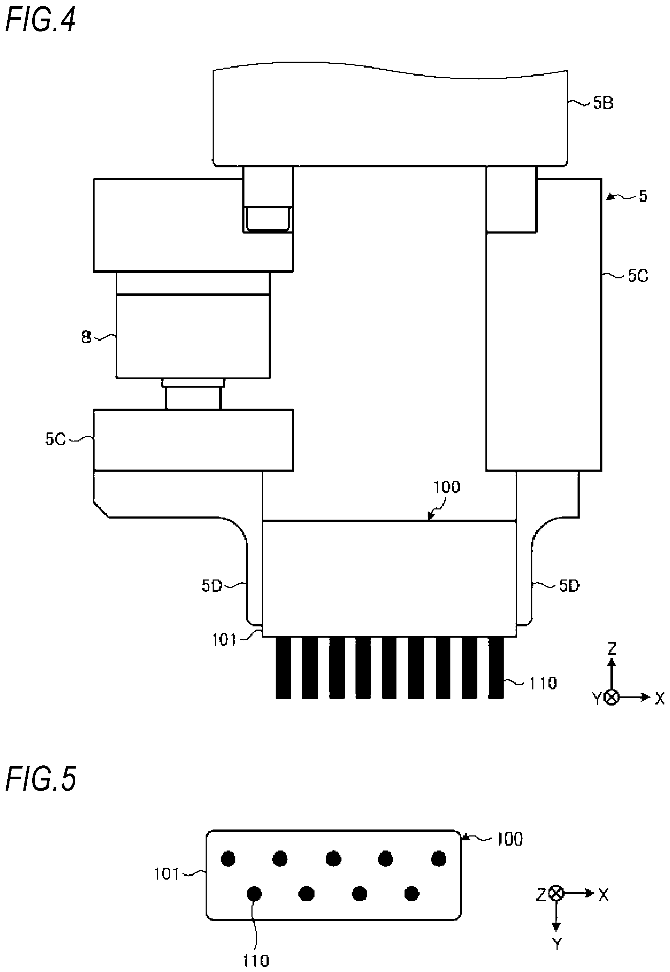

FIG. 4 is a side view showing the component 100 held by the robot hand 5 according to the embodiment. FIG. 5 shows the component 100 according to the embodiment as viewed from below.

The component 100 has a body portion 101 and a plurality of lead portions 110 protruding from the body portion 101. The lead portions 110 are an example of a protrusion protruding from the body portion 101.

The body portion 101 includes a housing made of synthetic resin. In an internal space of the body portion 101, an element such as a coil is arranged. The lead portions 110 are a metal protrusion protruding from the body portion 101. The lead portions 110 are connected to the element arranged in the internal space of the body portion 101, for example.

The lead portions 110 protrude downward from a lower surface of the body portion 101. With the component 100 mounted on the substrate 200, the lower surface of the body portion 101 faces the upper surface of the substrate 200.

The robot hand 5 holds the body portion 101 of the component 100. The pair of grip portions 5D holds the component 100 by sandwiching the body portion 101.

### [Three-Dimensional Measurement Device]

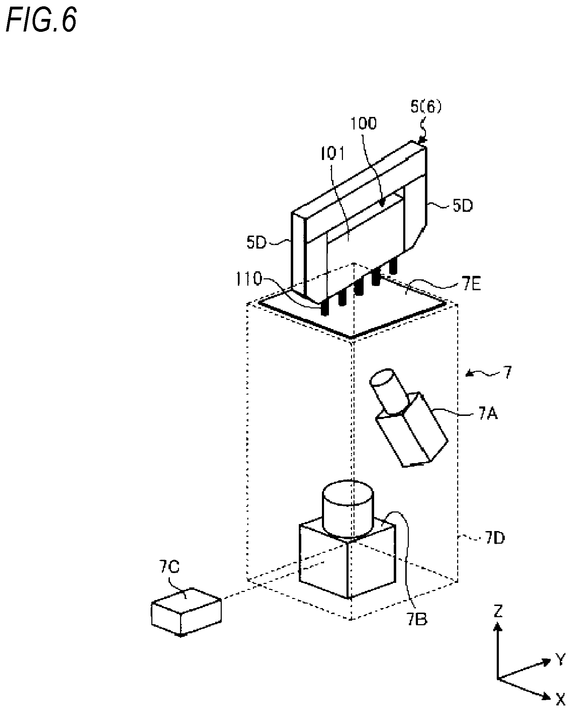

FIG. 6 is a perspective view showing the three-dimensional measurement device 7 according to the embodiment. As shown in FIG. 6, the three-dimensional measurement device 7 measures a three-dimensional shape of at least part of the component 100 while the body portion 101 is held by the robot hand 5.

The three-dimensional measurement device 7 includes a projection device 7A, an imaging device 7B, and a computing device 7C. In the embodiment, each of the projection device 7A and the imaging device 7B is accommodated in a housing 7D. Each of the projection device 7A and the imaging device 7B is fixed to the housing 7D. A transparent member 7E is arranged in an opening of an upper end portion of the housing 7D. As the transparent member 7E, a glass plate is exemplified.

The projection device 7A irradiates the component 100 with a stripe pattern light while the body portion 101 is held by the robot hand 5. The projection device 7A includes a light source, a light modulation element that optically modulates light emitted from the light source to generate a stripe pattern light, and an emission optical system that emits the stripe pattern light generated by the light modulation element. Examples of the light modulation element include a digital mirror device (DMD), a transmissive liquid crystal panel, or a reflective liquid crystal panel.

The imaging device 7B captures an image of the component 100 irradiated with the stripe pattern light from a predetermined viewpoint. The viewpoint of the imaging device 7B refers to a relative imaging position and imaging angle of the imaging device 7B with respect to the component 100. The imaging device 7B includes an image forming optical system that forms an image of the stripe pattern light reflected from the component 100, and an imaging element that obtains image data of the component 100 via the image forming optical system. Examples of the imaging element include a complementary metal oxide semiconductor (CMOS) image sensor or a charge coupled device (CCD) image sensor.

In the embodiment, the imaging device 7B is an example of a three-dimensional sensor that detects the component 100. Imaging data of the component 100 captured by the imaging device 7B is an example of detection data of the component 100 detected by the three-dimensional sensor.

The computing device 7C performs measurement processing of a three-dimensional shape of at least part of the component 100 based on the imaging data of the component 100 captured by the imaging device 7B. The computing device 7C performs measurement processing of the three-dimensional shape of at least part of the component 100 based on a phase shift method. The measurement processing of the computing device 7C includes image processing of the imaging data of the component 100 captured by the imaging device 7B. The computing device 7C includes a computer system. The computing device 7C includes a processor such as a central processing unit (CPU), a memory such as a read only memory (ROM) or a random access memory (RAM), and an input/output interface including an input/output circuit capable of inputting and outputting signals and data.

The projection device 7A irradiates the component 100 with, for example, a stripe pattern light with a sinusoidal brightness distribution while shifting a phase. The component 100 held by the robot hand 5 is arranged above the transparent member 7E. The stripe pattern light emitted from the projection device 7A is irradiated to the component 100 through the transparent member 7E.

The imaging device 7B captures an image of the component 100 irradiated with the stripe pattern light. The imaging device 7B captures an image of the component 100 through the transparent member 7E. The imaging device 7B captures an image of the component 100 from below the component 100. The viewpoint of the imaging device 7B is defined as being below the component 100. When the robot manipulator 6 operates to change the position and angle of the component 100 held by the robot hand 5, the relative position and relative angle between the component 100 and the imaging device 7B change. As the relative position and relative angle between the component 100 and the imaging device 7B change, the relative viewpoint of the imaging device 7B with respect to the component 100 changes.

The computing device 7C performs image processing on the imaging data of the component 100 captured by the imaging device 7B based on the phase shift method, and calculates three-dimensional data representing a three-dimensional shape of the lead portions 110. The three-dimensional data of the lead portions 110 includes bent amounts of the lead portions 110 and coordinates of tip end portions of the lead portions 110 in a three-dimensional space defined by the local coordinate system. When an angle on a design value of the lead portion 110 with respect to the body portion 101 is set as an ideal angle, and an actual angle of the lead portion 110 with respect to the body portion 101 is set as an actual angle, the bent amount of the lead portion 110 refers to a difference between the ideal angle and the actual angle.

Note that the three-dimensional sensor may be, for example, a light detection and ranging (LiDAR). The LiDAR irradiates the component 100 with laser light while the body portion 101 is held by the robot hand 5. The LiDAR outputs three-dimensional point cloud data of the component 100 as detection data of the component 100 to the computing device 7C.

### [Operation of Robot Manipulator]

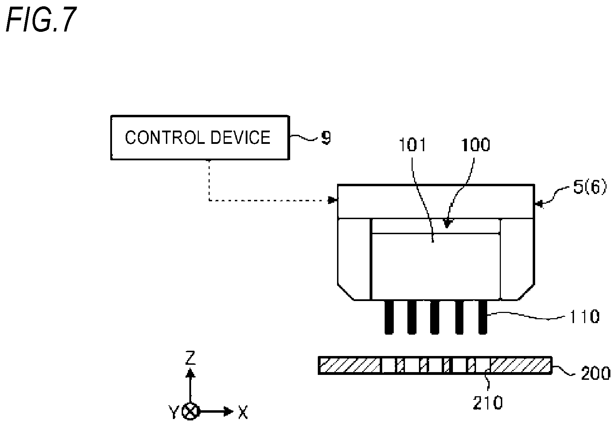

FIG. 7 is a diagram for illustrating an operation of the robot manipulator 6 according to the embodiment. The component mounting apparatus 1 includes a control device 9 that controls the robot manipulator 6. The control device 9 includes a computer system. As shown in FIG. 7, the substrate 200 is provided with holes 210 into which the lead portions 110 of the component 100 are inserted. The control device 9 controls the robot manipulator 6 so that the lead portions 110 of the component 100 are inserted into the holes 210 of the substrate 200, based on an image processing result of the computing device 7C of the three-dimensional measurement device 7.

### [Computing Device]

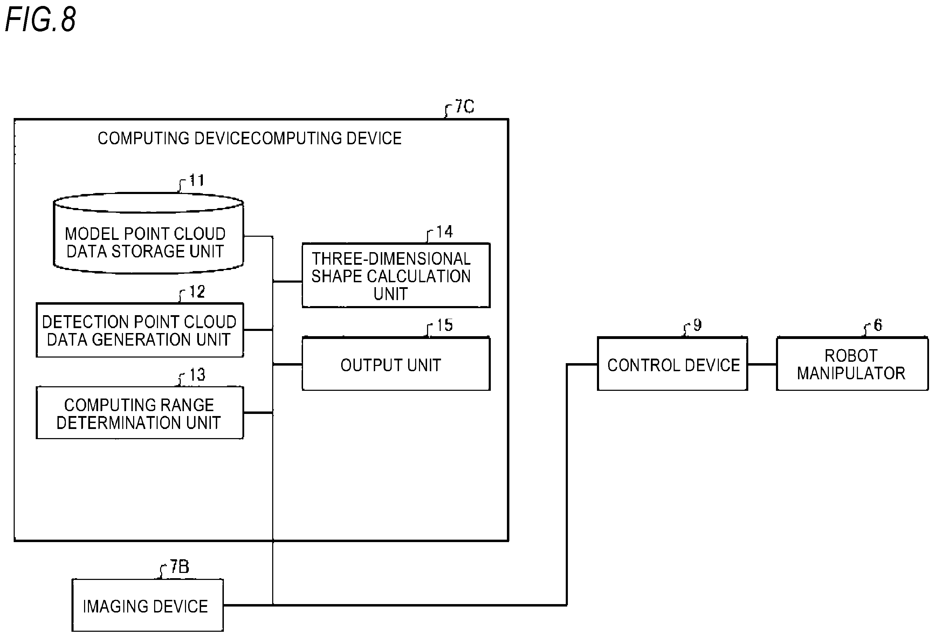

IG. 8 is a block diagram showing the component mounting apparatus 1 according to the embodiment. As shown in FIG. 8, the component mounting apparatus 1 includes the computing device 7C and the control device 9.

The computing device 7C includes a model point cloud data storage unit 11, a detection point cloud data generation unit 12, a computing range determination unit 13, a three-dimensional shape calculation unit 14, and an output unit 15.

The model point cloud data storage unit 11 stores model point cloud data Da representing three-dimensional point cloud data of a model of the lead portions 110. The model point cloud data Da is known data. The model point cloud data Da is three-dimensional point cloud data representing an ideal three-dimensional shape of the lead portions 110. The model point cloud data Da represents a three-dimensional shape of a model of the lead portions 110. The model point cloud data Da is an assembly of a plurality of measurement points on a surface of the model of the lead portions 110. A position of each of the plurality of measurement points is defined by an X coordinate, a Y coordinate, and a Z coordinate.

An ideal three-dimensional shape of the lead portions 110 includes a length of the lead portion 110 (ideal length), a relative position of the lead portion 110 with respect to the body portion 101 (ideal position), an angle of the lead portion 110 with respect to the body portion 101 (ideal angle), and an interval of the plurality of lead portions 110 (ideal interval).

The model point cloud data Da may be generated from design data of the lead portions 110. The design data of the lead portions 110 includes three-dimensional computer aided design (CAD) data.

Note that the model point cloud data Da need not be generated from the design data. When the lead portions 110 of an ideal three-dimensional shape, which is a shape of the design value, are measured by the three-dimensional measurement device 7, the model point cloud data Da may be generated from the three-dimensional data of the lead portions 110 of the ideal three-dimensional shape.

The detection point cloud data generation unit 12 generates detection point cloud data Db representing three-dimensional point cloud data of the component 100, based on a plurality of pieces of imaging data of the component 100 captured by the imaging device 7B from each of a plurality of viewpoints. The detection point cloud data generation unit 12 performs computing processing on the imaging data of the component 100 obtained from the imaging device 7B based on the phase shift method to generate three-dimensional image data of the component 100. The detection point cloud data generation unit 12 converts the generated three-dimensional image data into the detection point cloud data Db, which is three-dimensional point cloud data. The detection point group data Db represents a three-dimensional shape of the component 100. The detection point group data Db is an assembly of a plurality of measurement points on the surface of the component 100 by the three-dimensional measurement device 7. A position of each of the plurality of measurement points is defined by an X coordinate, a Y coordinate, and a Z coordinate.

Note that the detection point cloud data generation unit 12 may be provided in a computer (processor) different from the computing device 7C. That is, the processing of generating the detection point cloud data Db need not be performed in the computing device 7C.

Note that when the three-dimensional sensor is a LiDAR, the detection data of the component 100 detected by the LiDAR includes the detection point cloud data Db representing three-dimensional point cloud data of the component 100. Therefore, when the three-dimensional sensor is a LiDAR, the detection point cloud data generation unit 12 may be omitted.

The computing range determination unit 13 compares the model point group data Da of the lead portions 110 with the detection point group data Db of the component 100 to determine a computing range CS of the detection point group data Db.

In the embodiment, comparing the model point cloud data Da and the detection point cloud data Db includes matching the model point cloud data Da and the detection point cloud data Db. Matching the model point cloud data Da and the detection point cloud data Db includes searching for a relative position between the model point cloud data Da and the detection point cloud data Db where a degree of coincidence between the model point cloud data Da and the detection point cloud data Db becomes high. The computing range determination unit 13 determines the computing range CS based on the degree of coincidence between the model point cloud data Da and the detection point cloud data Db. The computing range determination unit 13 performs search processing of searching for the relative position between the model point cloud data Da and the detection point cloud data Db where the degree of coincidence between the model point cloud data Da and the detection point cloud data Db becomes high.

The computing range determination unit 13 performs search processing based on a specified algorithm. The search processing includes an amount of movement ΔX in the X-axis direction of the model point cloud data Da, an amount of movement ΔY in the Y-axis direction of the model point cloud data Da, an amount of movement AZ in the Z-axis direction of the model point cloud data Da, an amount of rotation ΔθX in the θX direction of the model point cloud data Da, an amount of rotation ΔθY in the θY direction of the model point cloud data Da, and an amount of rotation ΔθZ in the θZ direction of the model point cloud data Da for aligning the model point cloud data Da with the detection point cloud data Db.

Examples of the specified algorithm include an iterative closest point (ICP) algorithm, a normal distributions transform (NDT) scan matching, and a features from accelerated segment test (FAST) feature point matching. The computing range determination unit 13 performs matching between the model point cloud data Da and the detection point cloud data Db based on an existing algorithm.

The computing range determination unit 13 determines a computing range CS that does not include the body portion 101 and includes the lead portions 110, based on a comparison result between the model point cloud data Da and the detection point cloud data Db. That is, the computing range determination unit 13 determines, as the computing range CS, a part of the detection point cloud data Db aligned with the model point cloud data Da so that the degree of coincidence between the model point cloud data Da and the detection point cloud data Db becomes high. Determining a part of the detection point cloud data Db of the component 100 as the computing range CS includes extracting partial point cloud data Dc representing the detection point cloud data Db of only the lead portions 110 from the detection point cloud data Db of the entire component 100.

The three-dimensional shape calculation unit 14 calculates three-dimensional data representing the three-dimensional shape of the lead portions 110 based on the partial point cloud data Dc, which is the detection point cloud data Db in the computing range CS. As described above, the three-dimensional data of the lead portions 110 includes bent amounts of the lead portions 110 and coordinates of tip end portions of the lead portions 110 in a three-dimensional space defined by the local coordinate system.

The output unit 15 outputs the three-dimensional data of the lead portions 110 calculated by the three-dimensional shape calculation unit 14 to the control device 9. The measurement processing result of the computing device 7C includes three-dimensional data representing the three-dimensional shape of the lead portions 110 calculated by the three-dimensional shape calculation unit 14. The three-dimensional data of the lead portions 110 includes bent amounts of the lead portions 110 and coordinates of tip end portions of the lead portions 110. The control device 9 controls the robot manipulator 6 so that the lead portions 110 are inserted into the holes 210 of the substrate 200, based on the three-dimensional data of the lead portions 110.

### [Three-Dimensional Measurement Method For Lead Portions]

IG. 9 is a flowchart showing a three-dimensional measurement method for the lead portions 110 according to the embodiment. In order to mount the component 100 on the substrate 200, the control device 9 controls the robot manipulator 6 so that the robot hand 5 approaches the component supply member 3. The robot hand 5 moved to the component supply member 3 holds the body portion 101 of the component 100 arranged on the component supply member 3. After the body portion 101 of the component 100 is held by the robot hand 5, the control device 9 controls the robot manipulator 6 so that the component 100 held by the robot hand 5 is measured by the three-dimensional measurement device 7. That is, the control device 9 controls the robot manipulator 6 so that the component 100 held by the robot hand 5 is arranged above the three-dimensional measurement device 7, as described with reference to FIG. 6.

In the embodiment, the control device 9 controls the robot manipulator 6 so that the component 100 is captured by the imaging device 7B from each of a plurality of viewpoints. That is, the control device 9 controls the robot manipulator 6 so that the position and angle of the component 100 held by the robot hand 5 changes above the three-dimensional measurement device 7. The imaging device 7B captures an image of the component 100 from each of the plurality of different viewpoints.

The computing range determination unit 13 obtains the model point cloud data Da representing the three-dimensional point cloud data of the model of the lead portions 110 from the model point cloud data storage unit 11 (step S10).

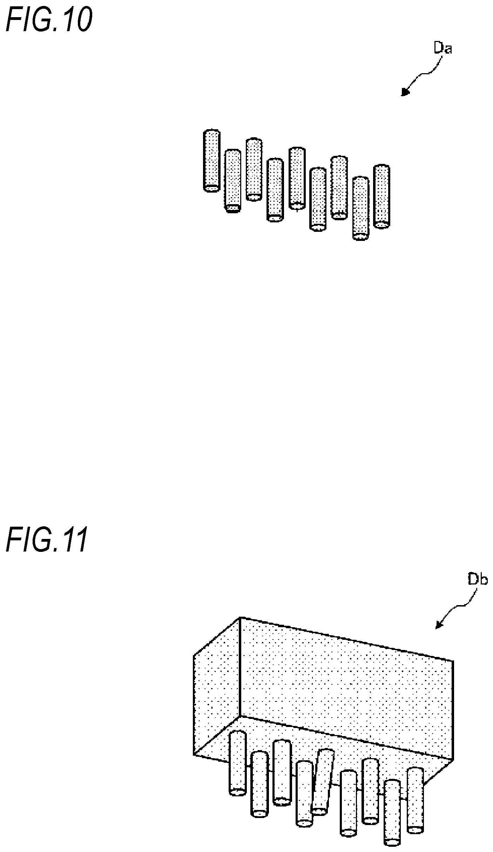

FIG. 10 schematically shows an example of the model point cloud data Da according to the embodiment. As shown in FIG. 10, in the model point cloud data Da, measurement points are provided on the entire surface of the lead portions 110. In the model point cloud data Da, there is no missing measurement point. In the model point cloud data Da, the measurement points are ideally arranged.

The detection point cloud data generation unit 12 obtains a plurality of pieces of imaging data of the component 100 captured from each of the plurality of viewpoints by the imaging device 7B. The detection point cloud data generation unit 12 generates the detection point cloud data Db of the component 100 based on the plurality of pieces of imaging data of the component 100 captured from each of the plurality of viewpoints (step S20).

FIG. 11 schematically shows an example of the detection point cloud data Db according to the embodiment. When the component 100 is captured from the plurality of viewpoints, the detection point cloud data generation unit 12 generates a plurality of pieces of detection point cloud data Db of the component 100 seen from each of the plurality of viewpoints. For example, when the component 100 is captured from three viewpoints, the detection point cloud data generation unit 12 generates first detection point cloud data Db1 of the component 100 as seen from a first viewpoint, second detection point cloud data Db2 of the component 100 as seen from a second viewpoint, and third detection point cloud data Db3 of the component 100 as seen from a third viewpoint. Note that two pieces of detection point cloud data Db seen from each of two viewpoints may be generated, or a plurality of pieces of detection point cloud data Db seen from each of four or more arbitrary viewpoints may be generated.

Depending on the relative imaging position and imaging angle of the imaging device 7B with respect to the component 100, the imaging device 7B may not be able to capture an image of the entire component 100. That is, depending on the viewpoint of the imaging device 7B, a blind spot may occur in the component 100, and thus a range that cannot be captured by the imaging device 7B may occur in the component 100. In the detection point group data Db, there is a case where the measurement points are not provided on at least part of the surface of the body portion 101. Additionally, in the detection point group data Db, there is a case where the measurement points are not provided on at least part of the surfaces of the lead portions 110. That is, there may be missing measurement points in the detection point group data Db. The detection point cloud data generation unit 12 may integrate the plurality of pieces of detection point cloud data Db1, Db2, and Db3 generated from each of the imaging data of the component 100 captured from a plurality of viewpoints to generate one piece of detection point cloud data Db of the component 100.

Note that the detection point cloud data generation unit 12 need not integrate the plurality of pieces of detection point cloud data Db1, Db2, and Db3. Additionally, when the three-dimensional sensor is a LiDAR, the detection data of the component 100 detected by the LiDAR includes the detection point cloud data Db representing three-dimensional point cloud data of the component 100. Therefore, when the three-dimensional sensor is a LiDAR, the processing of the detection point cloud data generation unit 12 may be omitted.

Note that the detection point group data Db shown in FIG. 11 shows an example in which one lead portion 110 among nine lead portions 110 is slightly bent.

The computing range determination unit 13 compares the model point group data Da of the lead portions 110 with the detection point group data Db of the component 100 to determine a computing range CS of the detection point group data Db (step S30).

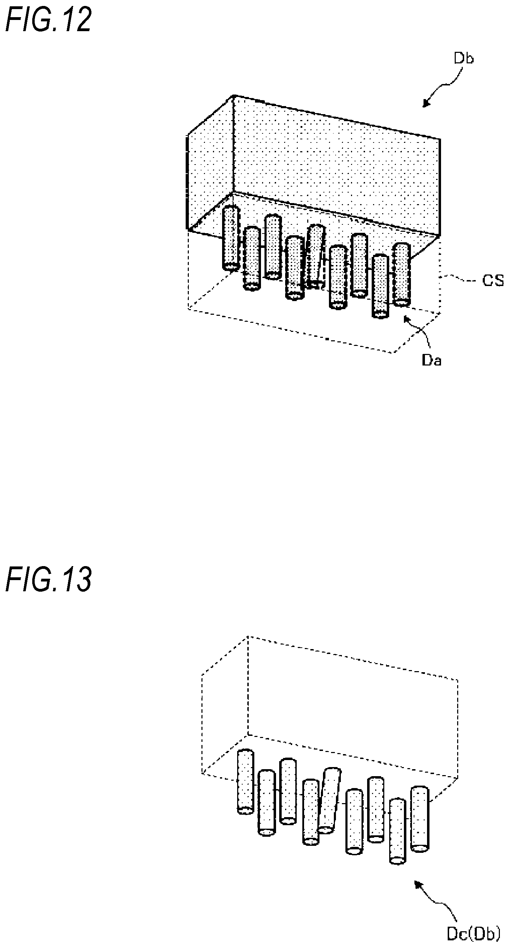

FIG. 12 is a diagram for illustrating a method for determining a computing range CD according to the embodiment. In the embodiment, comparing the model point cloud data Da and the detection point cloud data Db includes matching the model point cloud data Da and the detection point cloud data Db. Matching the model point cloud data Da and the detection point cloud data Db includes searching for a relative position between the model point cloud data Da and the detection point cloud data Db where a degree of coincidence between the model point cloud data Da and the detection point cloud data Db becomes high. The computing range determination unit 13 determines the computing range CS based on the degree of coincidence between the model point cloud data Da and the detection point cloud data Db. The computing range determination unit 13 performs search processing of searching for the relative position between the model point cloud data Da and the detection point cloud data Db where the degree of coincidence between the model point cloud data Da and the detection point cloud data Db becomes high.

The computing range determination unit 13 performs search processing based on a specified algorithm. Examples of the specified algorithm include an iterative closest point (ICP) algorithm, a normal distributions transform (NDT) scan matching, and a features from accelerated segment test (FAST) feature point matching. The computing range determination unit 13 performs matching between the model point cloud data Da and the detection point cloud data Db based on an existing algorithm.

The computing range determination unit 13 determines a computing range CS that does not include the body portion 101 and includes the lead portions 110, based on a comparison result between the model point cloud data Da and the detection point cloud data Db. That is, the computing range determination unit 13 determines, as the computing range CS, a part of the detection point cloud data Db aligned with the model point cloud data Da so that the degree of coincidence between the model point cloud data Da and the detection point cloud data Db becomes high. Determining a part of the detection point cloud data Db of the component 100 as the computing range CS includes extracting partial point cloud data Dc representing the detection point cloud data Db of only the lead portions 110 from the detection point cloud data Db of the entire component 100.

FIG. 13 schematically shows an example of the partial point cloud data Dc according to the embodiment. As shown in FIG. 13, by comparing the model point cloud data Da of the lead portions 110 with the detection point cloud data Db of the entire component 100, the partial point cloud data Dc representing the detection point cloud data Db not including the body portion 101 and including only the lead portions 110 is extracted from the detection point cloud data Db of the entire component 100. The computing range determination unit 13 may delete the detection point cloud data Db of the body portion 101 using, for example, a pass-through filter.

The three-dimensional shape calculation unit 14 calculates three-dimensional data representing the three-dimensional shape of the lead portions 110 based on the partial point cloud data Dc, which is the detection point cloud data Db in the computing range CS (step S40). As described above, the three-dimensional data of the lead portions 110 includes bent amounts of the lead portions 110 and coordinates of tip end portions of the lead portions 110 in a three-dimensional space defined by the local coordinate system.

The output unit 15 outputs the three-dimensional data representing the three-dimensional shape of only the lead portions 110 calculated in step S40 to the control device 9. The three-dimensional data of only the lead portions 110 corresponds to a measurement processing result of the three-dimensional measurement device 7 (step S50).

The control device 9 controls the robot manipulator 6 so that the component 100 is mounted on the substrate 200 based on the three-dimensional data of the lead portions 110 output from the output unit 15. The three-dimensional data of the lead portions 110 includes bent amounts of the lead portions 110 and coordinates of tip end portions of the lead portions 110. The control device 9 controls the robot manipulator 6 so that the lead portions 110 are inserted into the holes 210 of the substrate 200, based on the three-dimensional data of the lead portions 110.

### [Computer System]

IG. 14 is a block diagram showing a computer system 1000 according to the embodiment. Each of the computing unit 7C and the control unit 9 includes a computer system 1000. The computer system 1000 includes a processor 1001 such as a central processing unit (CPU), a main memory 1002 including a volatile memory such as a read only memory (ROM) or a random access memory (RAM), a storage 1003, and an input/output interface 1004 including an input/output circuit. Each function of the computing device 7C and the control unit 9 is stored in the storage 1003 as a computer program. The processor 1001 reads the computer program from the storage 650, develops the computer same into the main memory 1002, and executes the foregoing processing in accordance with the computer program. Note that the computer program may be transmitted to the computer system 1000 via a network.

The computer program may cause the computer system 1000 to execute: obtaining model point cloud data Da representing three-dimensional point cloud data of a model of the lead portions 110 protruding from the body portion 101 of the component 100, comparing the model point cloud data Da and detection point cloud data Db representing the three-dimensional point cloud data of the component 100 detected by the three-dimensional sensor to determine a computing range CS of the detection point cloud data Db, and calculating a three-dimensional shape of the lead portions 110 based on partial point cloud data Dc that is the detection point cloud data Db in the computing range CS, in accordance with the above embodiment.

### [Effects]

As described above, the three-dimensional measurement device 7 includes the model point cloud data storage unit 11 that stores the model point cloud data Da representing three-dimensional point cloud data of the model of the lead portions 110, which are a protrusion protruding from the body portion 101 of the component 100, the computing range determination unit 13 that compares the model point cloud data Da with the detection point cloud data Db representing three-dimensional point cloud data of the component 100 detected by the three-dimensional sensor to determine the computing range CS of the detection point cloud data Db, and the three-dimensional shape calculation unit 14 that calculates the three-dimensional shape of the lead portions 110 based on the partial point cloud data Dc that is the detection point cloud data Db in the operation range CS.

According to the embodiment, by comparing the model point cloud data Da of the lead portions 110 with the detection point cloud data Db of the entire component 100, the partial point cloud data Dc representing the detection point cloud data Db not including the body portion 101 and including only the lead portions 110 is extracted from the detection point cloud data Db of the entire component 100. The three-dimensional shape calculation unit 14 calculates the three-dimensional shape of the lead portions 110 from the partial point cloud data Dc. In the embodiment, the processing of calculating the three-dimensional shape of the body portion 101 is reduced. When inserting the lead portions 110 of the component 100 into the holes 210 of the substrate 200, it is sufficient to know the three-dimensional data of the lead portions 110 (the bent amounts of the lead portions 110 and the coordinates of the tip end portions of the lead portions 110), and the three-dimensional data of the body portion 101 is highly likely to be unnecessary. In the embodiment, the three-dimensional data representing the three-dimensional shape of the lead portions 110 is calculated, and the three-dimensional data representing the three-dimensional shape of the body portion 101 is not calculated. This reduces the amount of calculation (computation load) by the computing device 7C. Since the amount of computation is reduced, the measurement processing of the three-dimensional shape of at least part of the component 100 mounted on the substrate 200 is accelerated.

### First Embodiment of the Invention

A first embodiment of the invention will be described. In the following description, components that are the same or equivalent to those in the above embodiment are given the same reference numerals, and descriptions of those components are simplified or omitted.

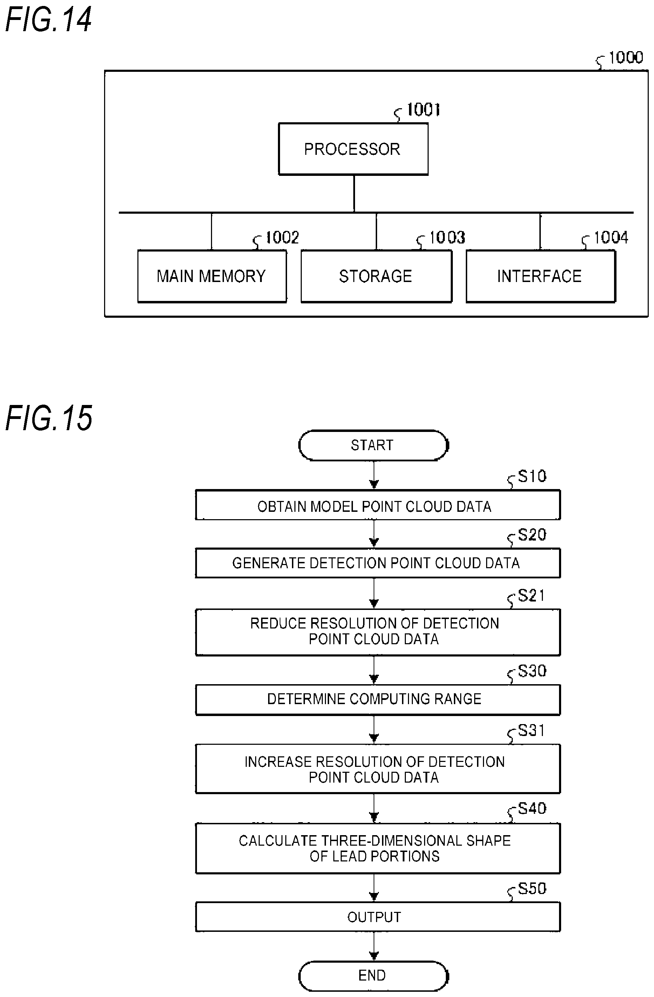

FIG. 15 is a flowchart showing a three-dimensional measurement method for the lead portions 110 according to an embodiment. Similar to the first embodiment, the computing range determination unit 13 obtains the model point cloud data Da representing the three-dimensional point cloud data of the model of the lead portions 110 from the model point cloud data storage unit 11 (step S10).

The detection point cloud data generation unit 12 obtains a plurality of pieces of imaging data of the component 100 captured from each of the plurality of viewpoints by the imaging device 7B. The detection point cloud data generation unit 12 generates the detection point cloud data Db of the component 100 based on the plurality of pieces of imaging data of the component 100 captured from each of the plurality of viewpoints (step S20).

The computing range determination unit 13 lowers a resolution of the detection point group data Db of the component 100. The computing range determination unit 13 lowers an initial resolution of the detection point cloud data Db generated by the detection point cloud data generation unit 12 in step S20 to a predetermined resolution lower than the initial resolution (step S21).

As described above, the detection point group data Db is an assembly of a plurality of measurement points on the surface of the component 100 by the three-dimensional measurement device 7. Lowering the resolution of the detection point cloud data Db includes thinning out the measurement points. That is, lowering the resolution of the detection point cloud data Db includes reducing the number of measurement points per unit volume. Lowering the resolution of the detection point cloud data Db includes lowering the density of measurement points.

When lowering the resolution of the detection point cloud data Db, the computing range determination unit 13 determines the resolution based on a size of an external shape of the lead portion 110. The computing range determination unit 13 lowers the resolution as the size of the external shape of the lead portion 110 increases.

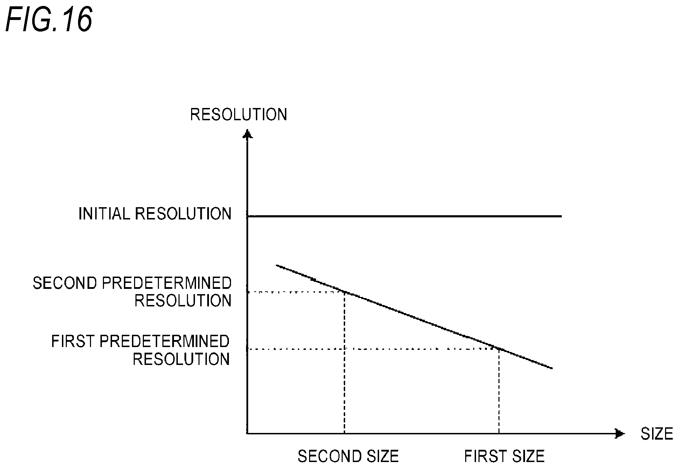

FIG. 16 is a diagram for illustrating a relationship between a size of the lead portion 110 and the resolution according to the embodiment. In the graph shown in FIG. 16, the horizontal axis represents the size of the lead portion 110, and the vertical axis represents the resolution. In the case of lowering the initial resolution of the detection point group data Db to a predetermined resolution, when the size of the external shape of the lead portion 110 is a first size, the computing range determination unit 13 lowers the initial resolution to a first predetermined resolution. When the size of the external shape of the lead portion 110 is a second size smaller than the first size, the computing range determination unit 13 lowers the initial resolution to a second predetermined resolution higher than the first predetermined resolution.

As shown in FIG. 16, in the embodiment, table data showing the relationship between the size of the lead portion 110 and the resolution is determined in advance. The size of the lead portion 110 is known data that can be known from the specification of the component 100. The computing range determination unit 13 determines how much to lower the initial resolution of the detection point cloud data Db based on the table data and the size of the lead portion 110.

The computing range determination unit 13 uses, for example, a voxel grid filter method to determine a resolution of 1/2 or less of minimum values of a width, a height, and a length of the lead portion 110.

The computing range determination unit 13 lowers the resolution of the detection point cloud data Db, and then compares the model point cloud data Da of the lead portions 110 with the detection point cloud data Db of the component 100 to determine the computing range CS of the detection point cloud data Db (step S30).

Similar to the first embodiment, which is not part of the invention, the computing range determination unit 13 performs search processing based on a specified algorithm. The computing range determination unit 13 performs matching between the model point cloud data Da and the detection point cloud data Db based on an existing algorithm.

After the computing range CS that does not include the body portion 101 and includes the lead portions 110 is determined, the three-dimensional shape calculation unit 14 increases the resolution of the detection point cloud data Db. The three-dimensional shape calculation unit 14 increases the predetermined resolution of the detection point cloud data Db determined in step S21 to the initial resolution higher than the predetermined resolution. That is, the three-dimensional shape calculation unit 14 returns the resolution of the detection point cloud data Db lowered in step S21 to the original resolution.

The three-dimensional shape calculation unit 14 increases the resolution of the detection point cloud data Db, and then calculates three-dimensional data representing the three-dimensional shape of the lead portions 110 based on the partial point cloud data Dc that is the detection point cloud data Db in the computing range CS (step S40).

The output unit 15 outputs the three-dimensional data representing the three-dimensional shape of only the lead portions 110 calculated in step S40 to the control device 9. The three-dimensional data of only the lead portions 110 corresponds to a measurement processing result of the three-dimensional measurement device 7 (step S50).

As described above, in the embodiment, when determining the computing range CS, the resolution of the detection point cloud data Db is lowered from the initial resolution to a predetermined resolution. This shortens the time required for calculation processing when determining the computing range CS.

The computing range determination unit 13 lowers the resolution of the detection point cloud data Db as the size of the lead portion 110 increases. When the size of the lead portion 110 is large, the resolution of the detection point cloud data Db is lowered to shorten the time required for calculation processing when determining the computing range CS. When the size of the lead portion 110 is small, if the resolution of the detection point cloud data Db is lowered excessively, the absolute number of measurement points constituting the lead portions 110 becomes too small, and as a result, it may be difficult to compare the model point cloud data Da of the lead portions 110 with the detection point cloud data Db of the component 100. When the size of the lead portion 110 is small, the computing range determination unit 13 can compare the model point cloud data Da of the lead portions 110 with the detection point cloud data Db of the component 100 by not lowering the resolution of the detection point cloud data Db excessively.

When calculating the three-dimensional data of the lead portions 110, the predetermined resolution of the detection point cloud data Db is returned to the initial resolution. When calculating the three-dimensional data, the resolution of the detection point cloud data Db is increased, so the three-dimensional data of the lead portions 110 is calculated with high accuracy.

### Others Embodiments.

In the above embodiments, the three-dimensional sensor is assumed to be the imaging device 7B that captures an image of the component 100 on which the stripe pattern light is projected by the projection device 7A. The three-dimensional sensor only needs to be able to detect the three-dimensional shape (three-dimensional point cloud data) of the component 100. As described above, the three-dimensional sensor may be, for example, a LiDAR. The three-dimensional sensor may be a stereo camera.

In the above embodiments, the protrusion of the component 100 is assumed to be the lead portions 110 made of metal. The protrusion may be made of synthetic resin. For example, as a protrusion, a boss portion made of synthetic resin may protrude from the body portion 101, and the boss portion may be inserted into the hole 210 of the substrate 200.

## Claims

1. A three-dimensional measurement device (7) for use in a component mounting apparatus (1), the three-dimensional measurement device (7) comprising:
a model point cloud data storage unit (11) in which model point cloud data (Da) representing three-dimensional point cloud data of a model of a protrusion (110) protruding from a body portion (101) of a component (100) is stored;
a computing range determination unit (13) configured to compare the model point cloud data (Da) with detection point cloud data (Db) representing three-dimensional point cloud data of the component (100) detected by a three-dimensional sensor to determine a computing range (CS) of the detection point cloud data (Db); and
a three-dimensional shape calculation unit (14) configured to calculate a three-dimensional shape of the protrusion (110) based on the detection point cloud data (Db) in the computing range (CS),
**characterized in that**
the computing range determination unit (13) is configured to determine the computing range (CS) by lowering a resolution of the detection point cloud data (Db) and then comparing the model point cloud data (Da) and the detection point cloud data (Db).

2. The three-dimensional measurement device (7) according to claim 1, wherein the computing range determination unit (13) is configured to determine the computing range (CS) based on a degree of coincidence between the model point cloud data (Da) and the detection point cloud data (Db).

3. The three-dimensional measurement device (7) according to claim 2, wherein the computing range determination unit (13) is configured to determine the computing range (CS) not comprising the body portion (101) and comprising the protrusion (110), based on a comparison result between the model point cloud data (Da) and the detection point cloud data (Db).

4. The three-dimensional measurement device (7) according to claim 1, wherein the computing range determination unit (13) is configured to lower the resolution as a size of the protrusion (110) increases.

5. The three-dimensional measurement device (7) according to claim 1, wherein the three-dimensional shape calculation unit (14) is configured to calculate the three-dimensional shape of the protrusion (110) after increasing the resolution of the detection point cloud data (Db).

6. The three-dimensional measurement device (7) according to claim 1, wherein the computing range determination unit (13) is configured to lower an initial resolution of the detection point cloud data (Db) generated by the detection point cloud data generation unit (12) to a predetermined resolution lower than the initial resolution.

7. The three-dimensional measurement device (7) according to claim 1, wherein the three-dimensional shape calculation unit (14) is configured to calculate three-dimensional data representing the three-dimensional shape of the protrusion (110).

8. The three-dimensional measurement device (7) according to claim 7, wherein the three-dimensional data of the protrusion (110) includes a bent amount of the protrusion and coordinates of tip end portion of the protrusion (110).

9. A component mounting apparatus (1) comprising:
a robot manipulator (6) configured to drive while maintaining a component (100) mounted on a substrate (200);
the three-dimensional measurement device (7) according to claim 1 configured to measure a three-dimensional shape of the component (100); and
a control device configured to control the robot manipulator (6) so that the component (100) is mounted on the substrate (200) based on a measurement processing result of the three-dimensional measurement device (7).

10. A three-dimensional measurement method comprising:
obtaining model point cloud data (Da) representing three-dimensional point cloud data of a model of a protrusion (110) protruding from a body portion (101) of a component (100);
comparing the model point cloud data (Da) with detection point cloud data (Db) representing three-dimensional point cloud data of the component (100) detected by a three-dimensional sensor to determine a computing range (CS) of the detection point cloud data (Db); and
calculating a three-dimensional shape of the protrusion (110) based on the detection point cloud data (Db) in the computing range (CS),
**characterized in that**
determining the computing range (CS) by lowering a resolution of the detection point cloud data (Db) and then comparing the model point cloud data (Da) and the detection point cloud data (Db).

11. The three-dimensional measurement method according to claim 10, further comprising:
calculating the three-dimensional shape of the protrusion (110) after increasing the resolution of the detection point cloud data (Db).

12. The three-dimensional measurement method according to claim 10, further comprising:
lowering an initial resolution of the detection point cloud data (Db) to a predetermined resolution lower than the initial resolution.

13. The three-dimensional measurement method according to claim 10, further comprising:
calculating three-dimensional data representing the three-dimensional shape of the protrusion (110).

14. The three-dimensional measurement method according to claim 13, wherein the three-dimensional data of the protrusion (110) includes a bent amount of the protrusion (110) and coordinates of tip end portion of the protrusion (110).

## Patentansprüche

1. Dreidimensionale Messeinrichtung (7) zur Verwendung in einer Komponentenmontagevorrichtung (1), wobei die dreidimensionale Messeinrichtung (7) umfasst:
eine Modellpunktwolkedaten-Speichereinheit (11), in welcher Modellpunktwolkedaten (Da) gespeichert sind, welche dreidimensionale Punktwolkedaten eines Modells eines Vorsprungs (110) repräsentieren, welcher von einem Körperbereich (101) einer Komponente (100) vorsteht;
eine Rechenbereich-Bestimmungseinheit (13), welche dazu ausgebildet ist, die Modellpunktwolkedaten (Da) mit Detektionspunktwolkedaten (Db) zu vergleichen, welche dreidimensionale Punktwolkedaten der Komponente (100) repräsentieren, welche mittels eines dreidimensionalen Sensors detektiert werden, um einen Rechenbereich (CS) der Detektionspunktwolkedaten (Db) zu bestimmen; und
eine Berechnungseinheit (14) für eine dreidimensionale Form, welche dazu ausgebildet ist, eine dreidimensionale Form des Vorsprungs (110) basierend auf den Detektionspunktwolkedaten (Db) in dem Rechenbereich (CS) zu berechnen,
**dadurch gekennzeichnet, dass**
die Rechenbereich-Bestimmungseinheit (13) dazu ausgebildet ist, den Rechenbereich (CS) zu bestimmen durch Verringern einer Auflösung der Detektionspunktwolkedaten (Db) und anschließendes Vergleichen der Modellpunktwolkedaten (Da) und der Detektionspunktwolkedaten (Db).

2. Dreidimensionale Messeinrichtung (7) nach Anspruch 1, wobei die Rechenbereich-Bestimmungseinheit (13) dazu ausgebildet ist, den Rechenbereich (CS) auf Basis eines Grades an Koinzidenz zwischen den Modellpunktwolkedaten (Da) und den Detektionspunktwolkedaten (Db) zu bestimmen.

3. Dreidimensionale Messeinrichtung (7) nach Anspruch 2, wobei die Rechenbereich-Bestimmungseinheit (13) dazu ausgebildet ist, den Rechenbereich (CS) zu bestimmen, welcher den Körperbereich (101) nicht umfasst, aber den Vorsprung (110) umfasst, basierend auf einem Vergleichsergebnis zwischen den Modellpunktwolkedaten (Da) und den Detektionspunktwolkedaten (Db).

4. Dreidimensionale Messeinrichtung (7) nach Anspruch 1, wobei die Rechenbereich-Bestimmungseinheit (13) dazu ausgebildet ist, die Auflösung mit zunehmender Größe des Vorsprungs (110) zu verringern.

5. Dreidimensionale Messeinrichtung (7) nach Anspruch 1, wobei die Berechnungseinheit (14) für eine dreidimensionale Form dazu ausgebildet ist, die dreidimensionale Form des Vorsprungs (110) nach Erhöhung der Auflösung der Detektionspunktwolkedaten (Db) zu berechnen.

6. Dreidimensionale Messeinrichtung (7) nach Anspruch 1, wobei die Rechenbereich-Bestimmungseinheit (13) dazu ausgebildet ist, eine anfängliche Auflösung der Detektionspunktwolkedaten (Db), welche mittels der Detektionspunktwolkedaten-Erzeugungseinheit (12) erzeugt werden, auf eine vorbestimmte Auflösung zu verringern, die niedriger ist als die anfängliche Auflösung,

7. Dreidimensionale Messeinrichtung (7) nach Anspruch 1, wobei die Berechnungseinheit (14) für eine dreidimensionale Form dazu ausgebildet ist, dreidimensionale Daten zu berechnen, welche die dreidimensionale Form des Vorsprungs (110) repräsentieren.

8. Dreidimensionale Messeinrichtung (7) nach Anspruch 7, wobei die dreidimensionalen Daten des Vorsprungs (110) einen Biegebetrag des Vorsprungs und Koordinaten eines Spitzenendbereichs des Vorsprungs (110) umfassen.

9. Komponentenmontagevorrichtung (1), umfassend:
einen Robotermanipulator (6), welcher dazu ausgebildet ist, zu fahren, während er eine Komponente (100) in einem auf einem Substrat (200) montierten Zustand hält;
die dreidimensionale Messeinrichtung (7) nach Anspruch 1, welche dazu ausgebildet ist, eine dreidimensionale Form der Komponente (100) zu messen; und
eine Steuereinrichtung, welche dazu ausgebildet ist, den Robotermanipulator (6) zu steuern, so dass die Komponente (100) basierend auf einem Messungsverarbeitungsergebnis der dreidimensionalen Messeinrichtung (7) auf dem Substrat (200) montiert ist.

10. Ein dreidimensionales Messverfahren, umfassend:
Erhalten von Modellpunktwolkedaten (Da), welche dreidimensionale Punktwolkedaten eines Modells eines Vorsprungs (110) repräsentieren, welcher von einem Körperbereich (101) einer Komponente (100) vorsteht;
Vergleichen der Modellpunktwolkedaten (Da) mit Detektionspunktwolkedaten (Db), welche dreidimensionale Punktwolkedaten der Komponente (100) repräsentieren, welche mittels eines dreidimensionalen Sensors detektiert werden, um einen Rechenbereich (CS) der Detektionspunktwolkedaten (Db) zu bestimmen; und
Berechnen einer dreidimensionalen Form des Vorsprungs (110) basierend auf den Detektionspunktwolkedaten (Db) in dem Rechenbereich (CS),
**dadurch gekennzeichnet, dass**
der Rechenbereich (CS) bestimmt wird durch Verringern einer Auflösung der Detektionspunktwolkedaten (Db) und anschließendes Vergleichen der Modellpunktwolkedaten (Da) und der Detektionspunktwolkedaten (Db).

11. Dreidimensionales Messverfahren nach Anspruch 10, ferner umfassend:
Berechnen der dreidimensionalen Form des Vorsprungs (110) nach Erhöhung der Auflösung der Detektionspunktwolkedaten (Db).

12. Dreidimensionales Messverfahren nach Anspruch 10, ferner umfassend:
Verringern einer anfänglichen Auflösung der Detektionspunktwolkedaten (Db) auf eine vorbestimmte Auflösung, welche niedriger ist als die anfängliche Auflösung.

13. Dreidimensionales Messverfahren nach Anspruch 10, ferner umfassend:
Berechnen von dreidimensionalen Daten, welche die dreidimensionale Form des Vorsprungs (110) repräsentieren.

14. Dreidimensionales Messverfahren nach Anspruch 13, wobei die dreidimensionalen Daten des Vorsprungs (110) einen Biegebetrag des Vorsprungs (110) und Koordinaten eines Spitzenendbereichs des Vorsprungs (110) umfassen.

## Revendications

1. Dispositif de mesure tridimensionnelle (7) pour une utilisation dans un appareil de montage de composant (1), le dispositif de mesure tridimensionnelle (7) comprenant :
une unité de stockage de données de nuage de points de modèle (11) dans laquelle des données de nuage de points de modèle (Da) représentant des données de nuage de points tridimensionnelles d'un modèle d'une saillie (110) faisant saillie à partir d'une partie corps (101) d'un composant (100) sont stockées ;
une unité de détermination de plage d'informatisation (13) configurée pour comparer les données de nuage de points de modèle (Da) avec des données de nuage de points de détection (Db) représentant des données de nuage de points tridimensionnelles du composant (100) détectées par un capteur tridimensionnel pour déterminer une plage d'informatisation (CS) des données de nuage de points de détection (Db) ; et
une unité de calcul de forme tridimensionnelle (14) configurée pour calculer une forme tridimensionnelle de la saillie (110) sur la base des données de nuage de points de détection (Db) dans la plage d'informatisation (CS),
**caractérisé en ce que**
l'unité de détermination de plage d'informatisation (13) est configurée pour déterminer la plage d'informatisation (CS) en abaissant une résolution des données de nuage de points de détection (Db) et en comparant ensuite les données de nuage de points de modèle (Da) et les données de nuage de points de détection (Db).

2. Dispositif de mesure tridimensionnelle (7) selon la revendication 1, dans lequel l'unité de détermination de plage d'informatisation (13) est configurée pour déterminer la plage d'informatisation (CS) sur la base d'un degré de coïncidence entre les données de nuage de points de modèle (Da) et les données de nuage de points de détection (Db).

3. Dispositif de mesure tridimensionnelle (7) selon la revendication 2, dans lequel l'unité de détermination de plage d'informatisation (13) est configurée pour déterminer la plage d'informatisation (CS) ne comprenant pas la partie corps (101) et comprenant la saillie (110), sur la base d'un résultat de comparaison entre les données de nuage de points de modèle (Da) et les données de nuage de points de détection (Db).

4. Dispositif de mesure tridimensionnelle (7) selon la revendication 1, dans lequel l'unité de détermination de plage d'informatisation (13) est configurée pour abaisser la résolution à mesure qu'une taille de la saillie (110) augmente.

5. Dispositif de mesure tridimensionnelle (7) selon la revendication 1, dans lequel l'unité de calcul de forme tridimensionnelle (14) est configurée pour calculer la forme tridimensionnelle de la saillie (110) après l'augmentation de la résolution des données de nuage de points de détection (Db).

6. Dispositif de mesure tridimensionnelle (7) selon la revendication 1, dans lequel l'unité de détermination de plage d'informatisation (13) est configurée pour abaisser une résolution initiale des données de nuage de points de détection (Db) générées par l'unité de génération de données de nuage de points de détection (12) jusqu'à une résolution prédéterminée inférieure à la résolution initiale.

7. Dispositif de mesure tridimensionnelle (7) selon la revendication 1, dans lequel l'unité de calcul de forme tridimensionnelle (14) est configurée pour calculer des données tridimensionnelles représentant la forme tridimensionnelle de la saillie (110).

8. Dispositif de mesure tridimensionnelle (7) selon la revendication 7, dans lequel les données tridimensionnelles de la saillie (110) incluent une quantité de courbure de la saillie et des coordonnées de partie d'extrémité de pointe de la saillie (110).

9. Appareil de montage de composant (1) comprenant :
un manipulateur robotique (6) configuré pour se déplacer tout en maintenant un composant (100) monté sur un substrat (200) ;
le dispositif de mesure tridimensionnelle (7) selon la revendication 1 configuré pour mesurer une forme tridimensionnelle du composant (100) ; et
un dispositif de commande configuré pour commander le manipulateur robotique (6) de telle sorte que le composant (100) soit monté sur le substrat (200) sur la base d'un résultat de traitement de mesure du dispositif de mesure tridimensionnelle (7).

10. Procédé de mesure tridimensionnelle comprenant :
l'obtention de données de nuage de points de modèle (Da) représentant des données de nuage de points tridimensionnelles d'un modèle d'une saillie (110) faisant saillie à partir d'une partie corps (101) d'un composant (100) ;
la comparaison des données de nuage de points de modèle (Da) avec des données de nuage de points de détection (Db) représentant des données de nuage de points tridimensionnelles du composant (100) détectées par un capteur tridimensionnel pour déterminer une plage d'informatisation (CS) des données de nuage de points de détection (Db) ; et
le calcul d'une forme tridimensionnelle de la saillie (110) sur la base des données de nuage de points de détection (Db) dans la plage d'informatisation (CS),
**caractérisé par**
la détermination de la plage d'informatisation (CS) en abaissant une résolution des données de nuage de points de détection (Db) et en comparant ensuite les données de nuage de points de modèle (Da) et les données de nuage de points de détection (Db).

11. Procédé de mesure tridimensionnelle selon la revendication 10, comprenant en outre :
le calcul de la forme tridimensionnelle de la saillie (110) après l'augmentation de la résolution des données de nuage de points de détection (Db).

12. Procédé de mesure tridimensionnelle selon la revendication 10, comprenant en outre :
l'abaissement d'une résolution initiale des données de nuage de points de détection (Db) jusqu'à une résolution prédéterminée inférieure à la résolution initiale.

13. Procédé de mesure tridimensionnelle selon la revendication 10, comprenant en outre :
le calcul de données tridimensionnelles représentant la forme tridimensionnelle de la saillie (110).

14. Procédé de mesure tridimensionnelle selon la revendication 13, dans lequel les données tridimensionnelles de la saillie (110) incluent une quantité de courbure de la saillie (110) et des coordonnées de partie d'extrémité de pointe de la saillie (110).
